Europäisches Patentamt

European Patent Office

Office européen des brevets

(19)

(11) **EP 0 403 267 B1**

(12) **EUROPEAN PATENT SPECIFICATION**

(45) Date of publication and mention
of the grant of the patent:
**27.11.1996 Bulletin 1996/48**

(51) Int Cl.$^6$: **H01L 27/088**

(21) Application number: **90306462.4**

(22) Date of filing: **13.06.1990**

(54) **Semiconductor device**

Halbleiteranordnung

Dispositif semi-conducteur

(84) Designated Contracting States:
**DE FR GB NL**

(30) Priority: **15.06.1989 JP 153425/89**

(43) Date of publication of application:
**19.12.1990 Bulletin 1990/51**

(73) Proprietor: **Matsushita Electronics Corporation
Kadoma-shi, Osaka 571 (JP)**

(72) Inventor: **Kudoh, Hitoshi
Kyoto-shi, Kyoto-fu 612 (JP)**

(74) Representative: **Crawford, Andrew Birkby et al
A.A. THORNTON & CO.
Northumberland House
303-306 High Holborn
London WC1V 7LE (GB)**

(56) References cited:
**US-A- 4 695 866**

• ELECTRONICS INTERNATIONAL, vol. 53, no. 13,
June 1980, pages 73-74, New York, US; K.
DREYFACK: "Multiple-drain MOS packs in very
fast logic gates"

## Description

The present invention relates to a semiconductor device.

In semiconductor devices, especially integrated circuit devices using MOS transistors, there is a mounting demand for smaller size and higher speed as the system is being enhanced in function and enlarged in capacity more and more. As a result, a device having a design rule of 1 μm or less has been realized.

The MOS transistor used in such devices is composed of one source, one drain and one gate. As the device size is shrunk, in order to maintain the device characteristics, the source and drain in the device are composed by forming a diffusion layer called LDD, or the gate electrode is made of refractory metals or refractory metal silicide. However, even if the device is further shrunk, the basic structure of the MOS transistor is unchanged, comprising one source, one drain and one gate.

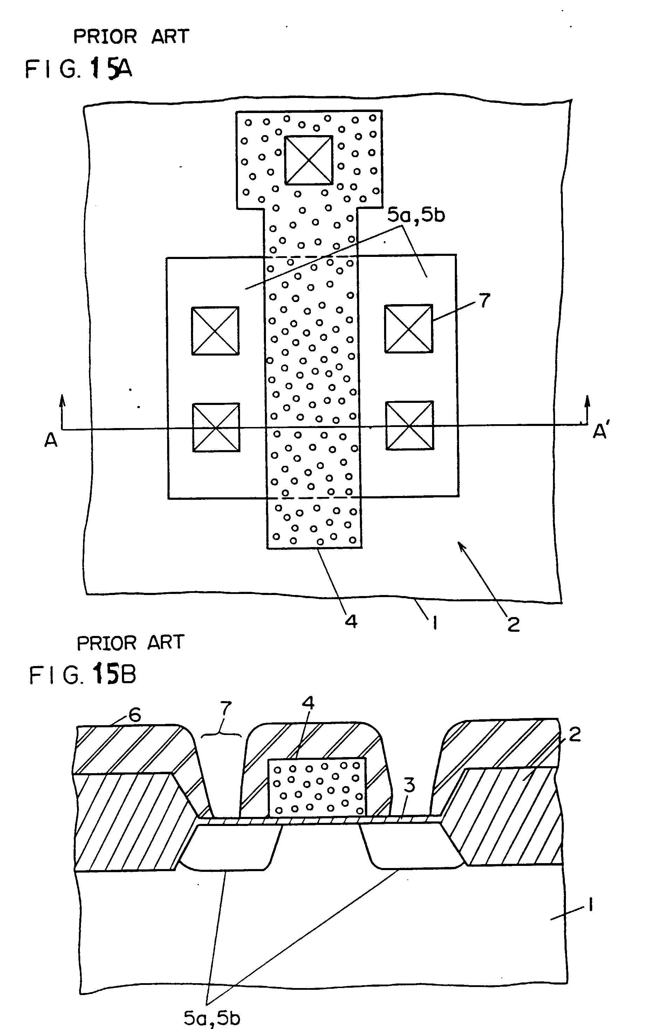

A plan view and a sectional view of a conventional MOS transistor are shown in Fig. 15.

A field oxide film 2 for separating devices is formed on a substrate 1. A device is formed in a region enclosed by the field oxide film 2. The device is composed by forming a source 5a and a drain 5b by introducing impurities of the reverse conductive type of the substrate 1 into the substrate 1. In the region between the source 5a and the drain 5b, a gate oxide film 3 is formed on the substrate 1. A gate electrode 4 is formed on the gate oxide film 3. The structure of only one device is shown here, but in an actual integrated circuit device, a plurality of such devices are disposed, and the desired devices are connected with metal wiring to make up an intended circuit. Meanwhile, an insulation film 6 is formed on the entire surface of the device so as to avoid malfunction due to electric contact by the metal wiring mutually connecting the elements. The metal wiring connecting the devices must contact with the source 5a, drain 5b, or the gate electrode 4. Therefore, specific regions of the insulation film 6 are removed by etching, and contact holes 7 for connecting the metal wirings are formed.

There are, however, functions that cannot be realized or hardly realized by the aforesaid construction of the conventional devices, and the development of devices having such functions is being awaited.

One of such desired functions is that, when a specific device is fabricated, what must be taken into consideration when designing a circuit having a certain function is to design a circuit capable of realizing a high yield in the aspect of fabrication of circuit while operating stably as the designed circuit. That is, it is required to design so as to optimize the circuit operation and to have a sufficient allowance in the circuit operation. As the method for this purpose, for example, it is known to design a basic circuit for optimizing the circuit operation, manufacture the designed device, measure the characteristic of the device, and estimate the characteristic of the intended circuit on the basis of the measured characteristic. In an other method, it is known to stimulate the operation of a desired circuit by a computer by using the preliminarily extracted parameters of device fabrication and device characteristic.

In both methods, nevertheless, the connecting manners of the transistors, resistors, capacitors and other components of the circuit are determined together with the input and output method and entire circuit construction, and still more the characteristics of the individual elements such as transistors, resistors and capacitors must be predetermined.

The circuit composition may be relatively easily determined by the logic design. On the other hand, the characteristics of individual elements differ depending on the manufacturing conditions, manufacturing equipment, or difference in substrates among manufacturing lots even in identical manufacturing conditions. Accordingly, if a multiplicity of identical devices should be manufactured, discrepancies of characteristics occur among the devices. Therefore, if the allowance of operation of the device characteristics on the whole is discussed by making routine measurement of device characteristics, circuits of high reliability will not be expected. To the contrary, if all device characteristics are carefully examined by fabricating basic circuits or simulating, it takes enormous time and cost, and it is not practicable.

Incidentally, a nerve circuit is used to bring the computer more closely to the human thinking manner.

A nerve circuit is composed as a matrix by organically coupling the individual nerve cells. To form such circuit composition by using transistors, the individual pieces are complicatedly combined and the wiring and other structures are very complicated, and it is hard to realize as a circuit.

The semiconductor device of the invention possesses a combined structure of several transistors. Hitherto, in the circuit composition, sharing of the gate, or sharing of the drain of a preceding transistor and the source of a succeeding transistor has been known (see for example US-A-4 695 866 and Electronics International, Vol.53 (1980) June, No.13, pp 73-4, the latter disclosing a multiple-drain MOSFET) whereas, in the invention, the element itself possesses plural transistors sharing a channel region. That is, the semiconductor device of the invention has plural transistors compounded in a form of sharing the gate and channel, and possesses three or more sources and drains.

In such constitution, not only the drain current is determined depending on the potential difference of the source and drain, but also the individual drain current increases or decreases depending on the condition of voltage applied to all source and drain terminals. In the invention, since there are three or more sources and drains, the drain current increases or decreases depending on the magnitude of the voltage applied to them. Therefore, assuming one of the plurality of source and drain terminals to be a control terminal (disturbance terminal) of the transistor having other sources and drains, instability or drift of the transistor operation may be intentionally produced by applying a proper voltage to the source and drain terminals.

Fig. 1(a) is a plan view of a semiconductor device according to a first embodiment of the invention,
Fig. 1(b) is a partially cut-away perspective view of A-A' of Fig. 1(a),
Fig. 2(a), Fig. 2(b) are conceptual diagrams for explaining the operation of the semiconductor device in Figs. 1(a), 1(b),
Fig. 3(a) , Fig. 3 (b) are equivalent circuit diagrams of the semiconductor device in Figs. 1(a), 1(b),
Fig. 4(a), Fig. 4(b) are plan view and equivalent circuit diagram for explaining the flow of the current in the semiconductor device in Figs. 1(a), 1(b),
Fig. 5 is a diagram showing the characteristics of the semiconductor device in Figs. 1(a), 1(b),
Fig. 6 is a plan view showing the structure of a semiconductor device useful for explaining the invention,
Fig 7(a), Fig. 7(b) are equivalent circuit diagrams of the semiconductor device in Fig. 6
Fig. 8 is a plan view of a semiconductor device according to a first embodiment of the invention,
Fig. 9(a) is a plan view of a semiconductor device according to a second embodiment of the invention,
Fig. 9(b), Fig. 9(c) are equivalent circuit diagrams of the semiconductor device in Fig. 9(a),
Fig. 10(a), Fig. 10(b), Fig. 10(c) are plan views of semiconductor devices in third, fourth, and fifth embodiments of the invention,
Fig. 11 is a diagram showing the characteristic of the semiconductor device in Fig. 10(c),
Fig. 12 is a plan view of a semiconductor device according to a sixth embodiment of the invention,
Fig. 13 is a circuit diagram showing an example of a circuit using the semiconductor device of the invention,
Fig. 14(a) is a plan view of a semiconductor device according to a seventh embodiment of the invention,
Fig. 14(b) is a sectional view of A-A' in Fig. 14(a),
Fig. 15(a) is a plan view of a conventional semiconductor device, and
Fig. 15(b) is a sectional view of A-A' in Fig. 15(a).

Referring now to the drawings, some of the embodiments of the invention are described in detail below.

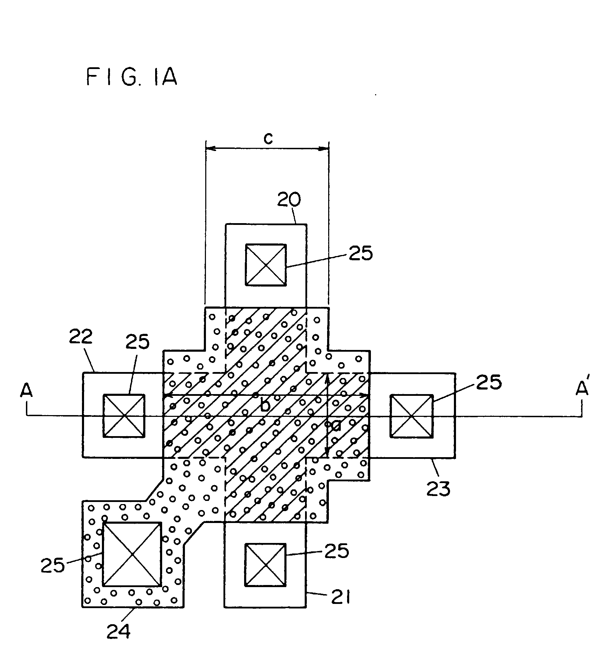

Fig. 1(a) is a plan view of a semiconductor device according to a first embodiment of the invention. A diffusion layer is formed of a pair of a first source 20 and a first drain 21, and a pair of a second source 22 and a second drain 23. A common gate 24 is formed in the region between the first source 20, first drain 21, second source 22 and second drain 23.

To achieve electric connections with diffusion layers, contact holes 25 are formed on the diffusion layer of the first source 20 and first drain 21, and the- diffusion layer of the second source 22 and second drain 23. Besides, the contact hole 25 of the common gate 24 is disposed in a region not contacting electrically with the-other diffusion layers.

The line linking the first source 20 and first drain 21 and the line linking the second source 22 and second source 23 intersect nearly at a right angle. In this embodiment, the channel width (indicated by "a" in Fig. 1 (a)) formed between the first source 20, first drain 21, and the second source 22, second drain 23 is set specific at about 10 μm. The channel length ("b" in Fig. 1 (a)) formed between the second source 22 and second drain 23 is about 12 μm.

The width of the common gate 24 ("c" in Fig. 1(a)) is about 12 μm. In the illustrated embodiment, the three ends of the square of the common gate 24 are notched, but such notching is not particularly required.

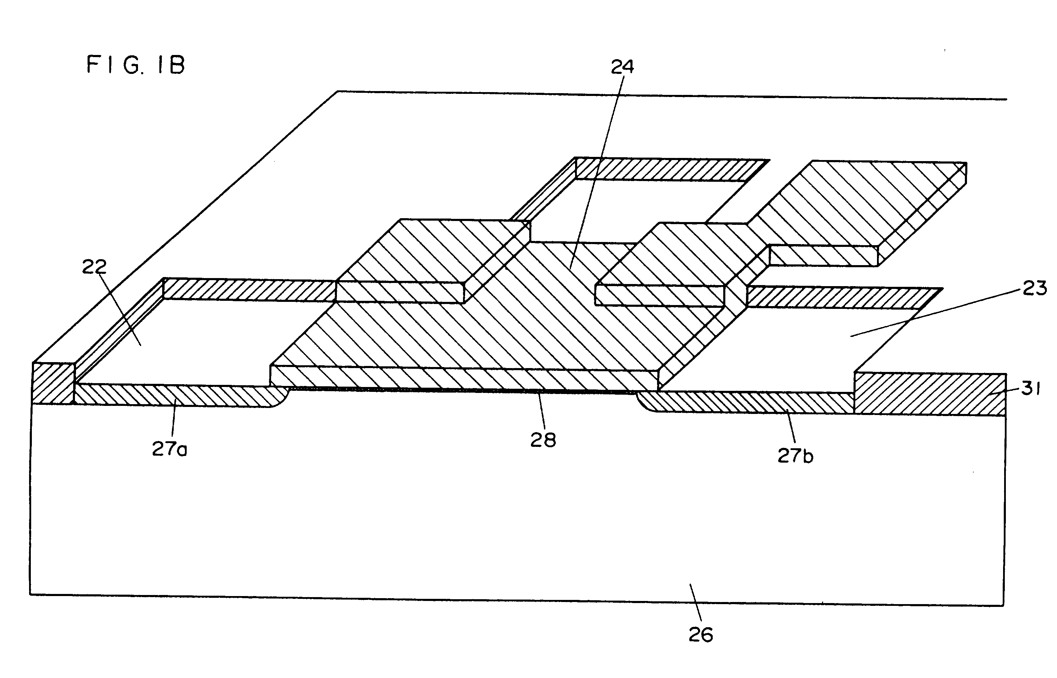

Fig. 1(b) is a perspective sectional view of the device as seen from line A-A′ in Fig. 1(a), but the contact holes 25 are not shown here.

On a substrate 26, a diffusion layer 27a of the second source 22 and a diffusion layer 27b of the second drain 23 are formed, and a gate oxide film 28 is formed between the two diffusion layers 27a, 27b, and a common gate 24 is formed on the gate oxide film 28. Thus, the sectional structure of the device in the first embodiment is exactly the same as that of the conventional MOS type device. As the substrate 26 in the first embodiment, a (100)P-type silicon substrate (resistivity 8 to 12 ohm-cm) is used, and by implanting boron ions to the first source 20, first drain 21, second source 22 and second drain 23, P-type diffusion layers 27a, 27b, 29a, 29b are formed, corresponding to the second source 22, second drain 23, first source 20, and first drain 21, respectively. The diffusion layers 29a, 29b are not shown in Fig. 1(b). The gate oxide film 28 is formed in a thickness of about 20 nm by steam oxidation. The common gate 24 is made of polysilicon formed by CVD.

The other regions on the substrate 26 than the areas for composing the contact holes 25 and common gate 24 are coated with an insulation film 31.

Here, for the ease of understanding by comparing the device of the invention with the conventional MOS type device, an example of forming the device by using a single crystal silicon substrate 26 is described, but it is not necessary to use a single crystal substrate, and other substrates may be used such as polycrystalline substrate or film, amorphous substrate or film, and others on which diffusion layers to be used as source and drain may be formed, for example, compound substrates, SOI (silicon-on-insulator) and SOS (silicon-on-sapphire). Needless to say, meanwhile, instead of the embodiment of N-channel type device using the P-type silicon substrate, the invention may be also applied to a P-channel type as well.

In this embodiment, the channel width "a" formed between the first, second sources 20, 22 and first, second drains 21, 23 is about 10 μm, and the channel length "b" is 12 μm, but the dimensions are not limited as far as a conventional MOS type device can operate, and a normal operation is guaranteed if the channel width "a" and channel length "b" are about 1.0 μm or more.

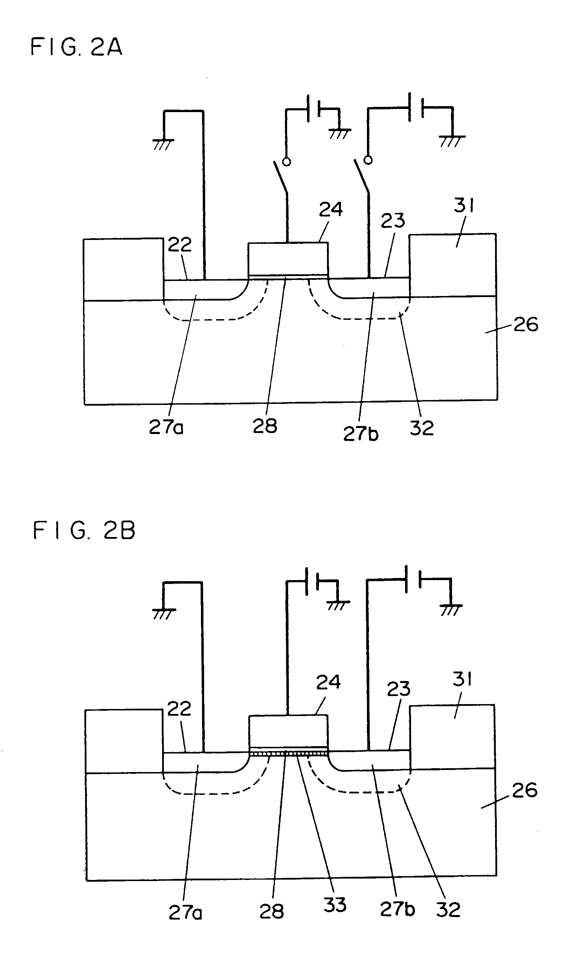

The operation of thus composed device is explained particularly below while referring to Fig. 2. Fig. 2(a) is a sectional view of the device in line A-A′ in Fig. 1(a) and the internal physical operation of the device is described referring to Fig. 2(a).

Fig. 2(a) shows a floating state of the first source 20 and first drain 21 by applying a specific potential between the second source 22 and second drain 23 and applying a specific voltage to the common gate 24. In Fig. 2(a), the diffusion layer 27a of the second source 22, the diffusion layer 27b of the second drain 23, the gate oxide film 28, and the common gate 24 are identical with those shown in Figs. 1(a), 1(b). In this case, a depletion layer 32 is formed at the junction of the P-type diffusion layers 27a, 27b and the substrate 26.

Fig. 2(b) shows a state which operating potentials are applied to the diffusion layers 27a, 27b and common gate 24. When a specified potential (e.g. 1.0 V) is applied between the common gate 24 and second drain 23, since the potential of the common gate 24 is higher than the threshold voltage of the transistor, a channel 33 called an inverted layer is formed on the surface of the silicon substrate 26 immediately beneath the gate oxide film 28. The channel 33 is connected to the diffusion layer 27a and diffusion layer 27b. The electrons generated in the diffusion layer 27a move to the diffusion layer 27b through the channel 33 by the electric field generated between the source diffusion layer 27a and drain diffusion layer 27b, and therefore an electric current flows. This action is exactly the same as that of a conventional MOS type device.

As the potential of the second drain 23 is further heightened, the depletion layer 32 formed in the periphery of the junction between the second drain 23 and the silicon substrate 26 spreads widely. As the depletion layer 32 is spread, the channel 33 formed immediately beneath the gate oxide film 28 can no longer reach the diffusion layer 27b of the second drain 23 (pinch-off), and the current does not increase even if the drain voltage is further raised, thereby reaching the saturated state.

As in this embodiment, in the device having two sets of source and drain, when the potential is applied to the second source 22 and second drain 23, and simultaneously to the first source 20 and first drain 21, the channel 33 formed immediately beneath the common gate 24 changes complicatedly corresponding to the potential of the second source 22 and second drain 23 and the potential of the first source 20 and first drain 21.

Thus, having plural pairs of source and drain, by varying the value of the potential applied to each source and drain, the drain current of the device may be intentionally increased or decreased. Besides, supposing one of the plurality of sources and drains to be a control terminal of the device having other source and drain pair, by applying an appropriate potential to the control terminal, the intrinsic characteristic may be varied, and the state of instability or drift in operation may be intentionally created.

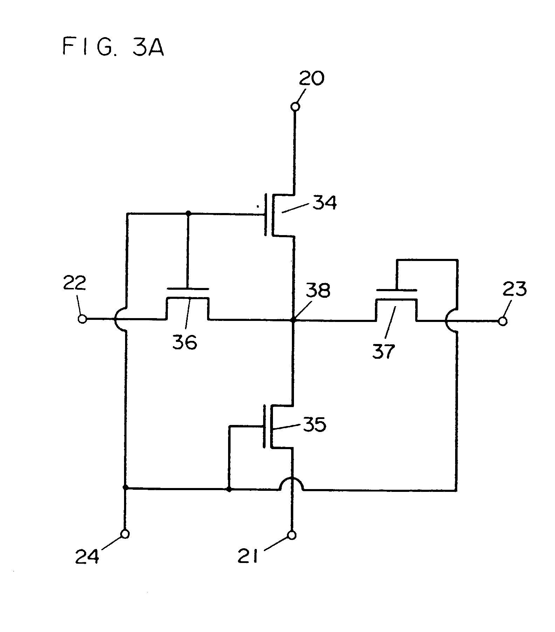

Fig. 3(a) shows an equivalent circuit of the device of Fig. 1(a). Between the first source 20 and first drain 21, MOS type transistors 34, 35 are connected in series. Between the second source 22 and second drain 23, MOS type transistors 36, 37 are connected in series. The gates of these four MOS type transistors 34, 35, 36, 37 are common gate 24. Furthermore, the sources and drains of the MOS type transistors 34, 35, 36, 37 are connected at one point 38.

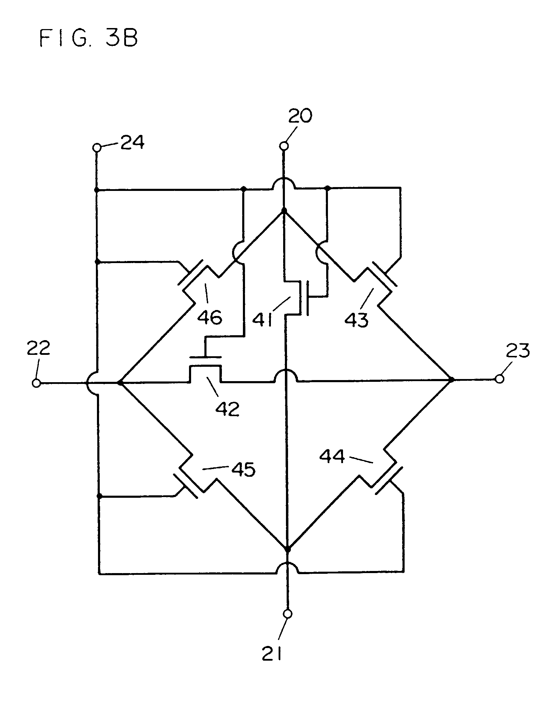

Incidentally, the equivalent circuit of the device shown in Fig. 1(a) may be expressed also as shown in Fig. 3(b). That is, a MOS type transistor 41 is formed between the first source 20 and first drain 21, and a MOS type transistor 42 between the second source 22 and second drain 23. Between the first source 20 and second drain 23, a MOS type transistor 43 is formed. Between the second drain 23 and first drain 21, a MOS type transistor 44 is formed, and between the first drain 21 and second source 22, a MOS type transistor 45 is formed. Furthermore, between the second source 22 and first source 20, a MOS type transistor 46 is formed. These MOS type transistor 43 to 46 share a common gate 24.

The operation of thus composed circuit is explained below. Assuming the first source 20 and first drain 21 to be source and drain of a device, respectively, the operating potential applied to the second source 22 and second drain 23 acts as a disturbance factor to cause instability or drift in the device characteristic of the device having the first source 20 and first drain 21 as source and drain, respectively. While the second source 22 and second drain 23 are in floating state, this device acts exactly the same as the conventional MOS type device. That is, a potential is applied to the common gate 24, and a channel is generated immediately beneath the common gate 24. Sequentially, depending on the potential applied to the first source 20 and first drain 21, a current flows in the channel area and the MOS type device operates.

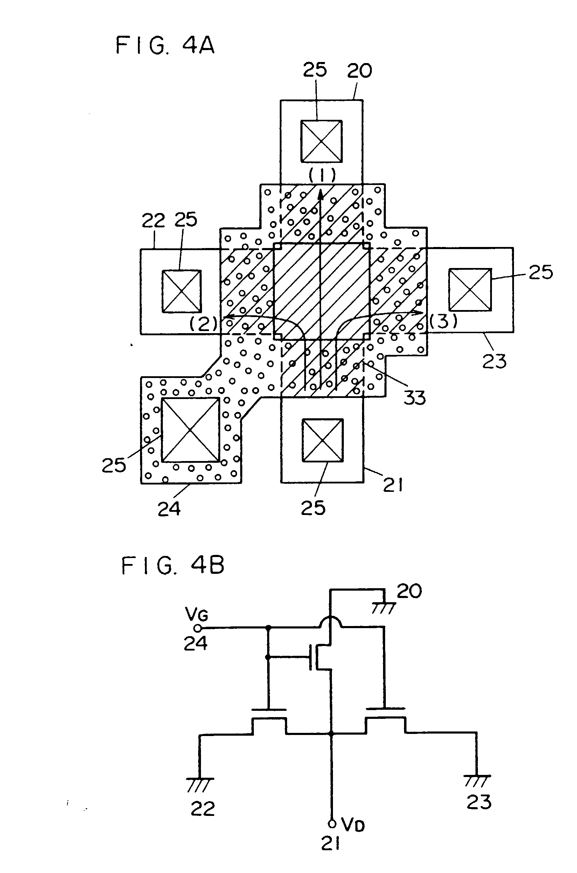

Fig. 4(a) shows the flow of current occurring when the second source 22 and second drain 23 are grounded.

In Fig. 4(a), the source, drain and gate have the same composition as shown in Fig. 1(a). The shaded area in Fig. 4(a) shows the generation region of the channel 33 beneath the gate electrode when a voltage over the threshold voltage is applied to the common gate 24. The arrows 1, 2, 3 in the shaded area indicate the flow direction of the current passing through the channel. When the first source 20 is ground and a voltage is applied to the first drain 21, the drain current flows in the direction of arrow 1. On the other hand, when the second source 22 and second drain 23 are grounded, the three MOS type transistors operate simultaneously. That is, the MOS type transistor having the first source 20 as the source and the first drain 21 as the drain (in Fig. 3(b), the MOS type transistor 41 corresponds to such transistor, and the flow of the current in Fig. 4 (a) corresponds to the direction of arrow 1), the MOS type transistor having the second source 22 as the source and the first drain 21 as the drain (in Fig. 3(b), the MOS type transistor 45 corresponds to such transistor, and the flow of the current in Fig. 4(a) corresponds to the direction of arrow 2), and the MOS type transistor having the second drain 23 as the source and the first drain 21 as the drain (in Fig. 3(b), the MOS type transistor 44 corresponds to such transistor, and the flow of the current in Fig. 4(a) corresponds to the direction of arrow 3) compose a device comprising one drain and three sources.

When the second source 22 and second drain 23 are grounded, as compared with the conventional MOS type transistor having the second source 22 and second drain 23 in floating state (without fixing the voltage), a current of about 1.4 times flows in the first drain 21.

When the MOS type transistor possesses a common gate, that is, in the device in Fig. 4(a), in the case that the MOS type transistors 41, 44, 45 possess the common gate 24, but not common channel, the drain current is merely obtained by the sum of the drain currents flowing through the transistors 41, 44, 45. However, the drain current obtained in the device of this embodiment varies the characteristic by affecting mutually more than in the case of the conventional MOS type element possessing common gate.

In the embodiment, the first source 20, the second source 22 and the second drain 23 are all grounded and are at same potential. A specific potential is applied only to the first drain 21, and therefore there is no potential difference between the first source 20 and second source 22, and between the first source 20 and second drain 23, and the elements formed between them do not operate. Generally, it is not required that the potential be identical between the first source 20 and second source 22, and the first drain 21 and second drain 23, and hence the first source 20, first drain 21, second source 22 and second drain 23 may be fixed at different potentials, individually. As a result, as shown in Fig. 4 (b), it may be possible to assume an equivalent circuit having the MOS type transistor disposed between the terminals.

Same as in the general MOS type transistor, also in the device shown in Fig. 1(b); the drain current increases as the gate voltage and drain voltage raise. This characteristic is fundamentally the same as the general MOS type transistor.

In fact, for example, when a specific voltage is applied to the first source 20 and first drain 21, and the other second source 22 and second drain 23 are in floating state, the same characteristics as the conventional MOS type transistor is obtained.

The drain voltage-drain current characteristic was examined when two out of four terminals of the device shown in Fig. 1(a) are floating. Hereinafter the terminals are not called by the names of source and drain. This is because the terminals may become either source or drain depending on the applied potential. In correspondence to Fig. 1(a), the first source 20 is terminal T1, the first drain 21 is terminal T3, the second source 22 is terminal T2, and the second drain 23 is terminal T4.

When two of the terminals of the device are floating in this way, two types of MOS type transistors differing in the channel shape are selected.

The relation between the drain-source voltage and the drain current (referred to as broken line A) of the device having terminals T3 and T4 in floating state was examined using the terminal T2 as the drain for applying a potential of 0 to 5 V and terminal T1 as the source with the potential set at 0 V. At this time, the potential of the common gate 24 varies from 0 to 5 V.

Thus, in the broken line A, the two terminals corresponding to the source and drain are disposed at right angle. Accordingly, the channel region is bent almost at right angle and the drain current flowing between the vertically arranged source and drain can be measured

An alternative referred to as solid line B examined the variation of the potential from 0 to 5 V in which all potentials of the terminals T2 and T4 are in floating state, the potential of terminal T1 is 0 V, and the terminal T3 is the drain. The potential applied to the common gate 24 is changed from 0 to 5 V.

Thus, in the solid line B, the two terminals corresponding to the source and drain are disposed linearly. Accordingly, the channel region is rectangular, same as in the ordinary MOS type transistor.

In the drain voltage-drain current characteristics in both broken line A and solid line B, as the gate voltage and drain voltage raise, the drain current increases, and above a certain drain voltage, there is a tendency of saturation of the drain current by pinchoff.

Generally, the drain current of the MOS type element is inversely proportional to the channel length and normally proportional to the channel width as shown in formula (1).

$$ID \propto W/L \qquad (1)$$

Comparing the W/L (ratio of mean channel width to mean channel length) of MOS type transistors of the above two curves (lines A and B), it is found

$$(W/L) A : (W/L)B = 1 : 0.90 \qquad (2)$$

and the drain current obtained by measurement is

$$\text{(ID)A: (ID) B} = 1 : 0.88 \tag{3}$$

and when a satisfactory correspondence is acknowledged.

That is, having plural pairs of source and drain, by varying the value of the potential applied to the individual sources and drains, the drain current flowing in the device may be intentionally increased or decreased. Accordingly, assuming one of the plurality of sources and drains to be a control terminal of the device possessing other pair of source and drain, by applying an appropriate potential to the control terminal, the intrinsic characteristic of the device may be changed, so that the state of instability or drift in operation may be intentionally created. Next, gate voltage and drain current were measured when a voltage is applied to the three terminals. A potential of 0 V was applied to terminal T1, 0.1 V to terminal T3, 0 V to terminal T4 and 0 V ot the substrate. The potential of terminal T2 is varied in a range of 0 to 5 V, and the gate potential is varied in a range of 0 to 2 V.

This device is regarded as a MOS type transistor having the terminals T1 and T4 as the source and the terminal T3 as the drain. The threshold voltage of thus formed MOS type transistor is about 0.7 V, and hence the drain current flowing from terminal T3 begins to flow at the gate potential of 0.7 V or more. However, when the voltage applied to the terminal T3 is gradually raised, the drain current flowing from the terminal T3 gradually decreases and finally begins to flow in the reverse direction.

It means that, as the potential of the terminal T2 is raised, the MOS type transistor having the terminal T2 as the drain begins to operate, in addition to the drain current of the terminal T3 flowing in the MOS type transistor having the terminals T1 and T4 as the source which had been operating so far. That is, in order to cause the terminals of the MOS type device to operate as the source or drain, it merely depends on which terminal has a higher potential. Therefore, if the potential of the terminal T2 is 0 V, the terminal T3 which is the drain is known to change to the source from around the point where the potential of the terminal T2 is about to exceed 0.1 V. What should be noted here is that the drain current is flowing in the terminal T2 even if the potential of the terminal T2 is 5 V and the potential of the gate is about 0.8 V.

More specifically, since the terminals T1 and T2 which are the source are at the same potential as the substrate, that is, 0 V, the threshold voltage of the MOS type device having the first operating terminal T2 as the drain is about 0.8 V. By contrast, the potential of the source which is the terminal T2 of the second operating MOS type element is 0.1 V higher than that of the substrate. As a result, a substrate bias sensitivity (body-effect) takes place, and the threshold voltage becomes about 1.0 V, and the gate potential operates at over 1.0 V, so that such drain current flows.

That is, when a voltage is applied to other terminals than the source and drain of the MOS type device to be observed, the original characteristic of the MOS type device may be varied.

In this way, assuming one of the plural sources and drains to be the control terminal of the device having other source and drain pair, by applying an appropriate potential to the control terminal, the intrinsic characteristic of the device may be varied, and the state of instability of drift may be intentionally created.

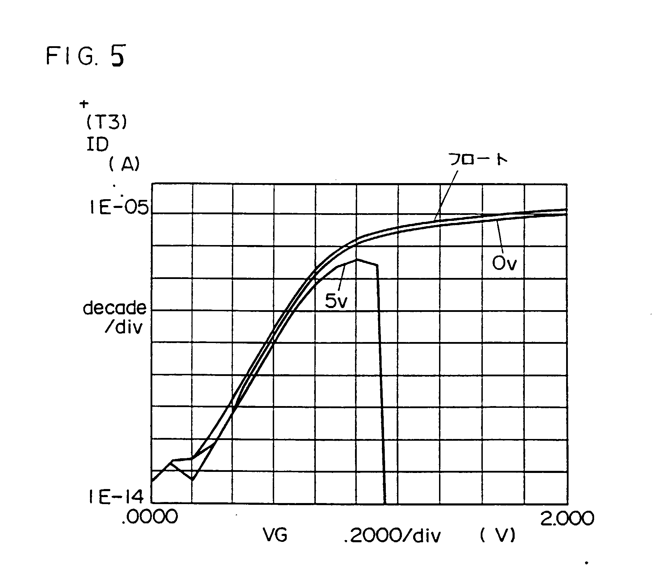

Fig. 5 shows the result of measurement of gate voltage and drain current in order to show that the apparent threshold voltage can be changed. In Fig. 5, the potential of the terminal T1 is 0 V, the terminal T2 is opened, the potential of terminal T3 is 0.1 V, and the potential of the terminal T4 is fixed at 0 V. Furthermore, the gate potential is changed in a range of 0 to 2 V, and the diagram shows the gate voltage dependence of the drain current flowing in the terminal T3 when 0 V is applied to the substrate.

In such device, the MOS type transistor is composed by using the terminals T1 and T4 as the source and T3 as drain. In the floating state in which the terminal T2 is opened, the potential of the terminal T2 is an intermediate value of the potential of the source and drain. When the potential of the terminal T2 is fixed at 0 V, the drain current flowing in the terminal T3 decreases. When the potential of the terminal T2 is raised, the terminal T2 acts as the drain, and the terminal T3 changes its role from drain to source. In other words, when the potential of the terminal T2 is varied in a range of 0 V to about drain potential, the characteristic is revised to have the threshold voltage about 0.05 V larger. The drain current flowing in terminal T3 at this time decreases about 50%.

An example of increase of the drain current by application of specific potential to other terminals than the source and drain was considered. However, the obtained value was only a current smaller than the drain current flowing in the ordinary MOS type transistor used by sharing the gate. On the other hand, in Fig. 5, when a specific potential is applied to other terminals than source and drain, the drain current decreases. These results are not contradictory, but differ depending on which terminals is regarded as the source and drain of the MOS type transistor.

To understand the characteristic of the device shown in Fig. 1(a), another structure is discussed below.

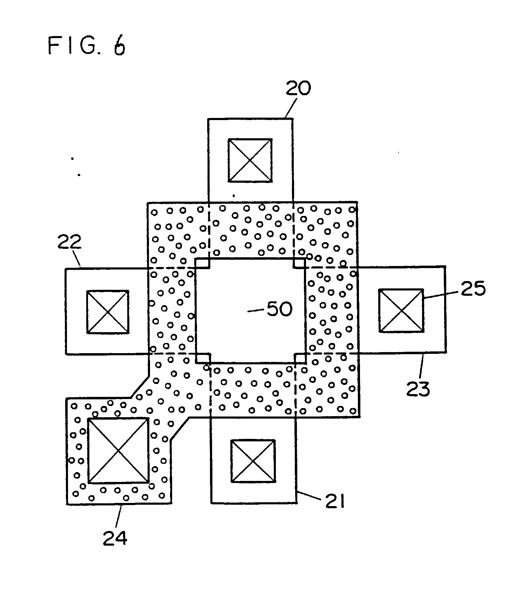

Fig. 6 shows an element having the middle portion cut out from the common gate 24 in the device shown in Fig. 1(a). The middle portion of the common gate 24 of the first source 20, first drain 21, second source 22, second drain 23 is cut out, so that the potential induced in the diffusion layer 50 in the middle portion can be taken out independently of the potential applied to other terminals.

The device shown in Fig. 6 exactly corresponds to the equivalent circuit of the device shown in Fig. 3(a).

By considering the potential of the diffusion layer 50 in the center portion of the common gate 24, it is enough to estimate how the voltages applied to the four MOS type transistors 34, 35, 36, 37 in Fig. 3(a) are distributed. Since the four MOS type transistors shown in Fig. 6 are exactly same in shape and size, a difference in drain voltage occurs depending on the applied voltage, in particular, the potential difference of the source and drain (in this case, the gate voltage is common).

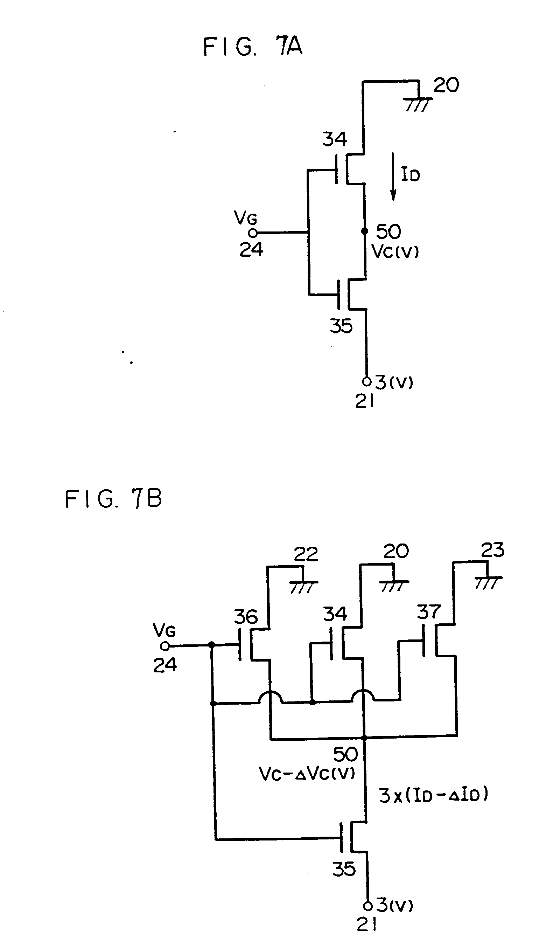

By grounding the first source 20 and applying a potential of 3 V to the first drain 21, when the second source 22 and second drain 23 are in floating state, the potential of the diffusion layer 50 in the center portion of the common gate 24 is an intermediate value of 0 and 3 V (this value is called Vc hereinafter). That is, a MOS type transistor using the first source 20 as the source, the diffusion layer 50 as the drain, and applying Vc to the drain, and a MOS type transistor using the diffusion layer 50 as the source, the first drain 21 as the drain, and apply a potential of Vc to the source and 3 V to the drain are arranged in series. The circuit diagram in this state is shown in Fig. 7(a).

Fig. 7(b) shows a circuit diagram in a state of grounding the second source 22 and second drain 23. The potential of the diffusion layer 50 is lowered from the potential Vc by $\Delta$Vc to be Vc - $\Delta$Vc. As a result, the drain current flowing in the MOS type transistor 34 in Fig. 7(b) decreases by $\Delta$ID. The three MOS type transistors 34, 36, 37 have substantially identical size, and hence a nearly equal drain current flows in the three MOS type transistors 34, 36, 37. Accordingly, the total drain current is 3 x (ID - $\Delta$ID), and the total drain current increases.

As explained in relation to Fig. 4(a), when the current of the first drain 21 is compared with the ordinary MOS type transistor having the second source 22 and second drain 23 in floating (without fixing voltage) state, a current flows which is about 1.4 times that which flows when the second source 22 and second drain 23 are grounded, which is because the drain current is determined by the function stated above. The drain current $\Delta$ID at this time is calculated to reach about 50% of the drain current ID.

The difference between the device shown in Fig. 1 (a) and the device having the structure shown in Fig. 6 is that the size of the device in Fig. 1(a) determined by the channel length and channel width varies with the condition of the potential applied to the terminals, while the device shown in Fig. 6 does not have four MOS type elements of nearly same channel length and channel width in a symmetrical element because the channel is formed only immediately beneath the common gate. Accordingly, the size of the device is determined when the device is formed in the substrate. Depending on the condition of the potential applied to the terminals, the potential of the diffusion layer 50 varies, and the operation of the entire circuit, formed by four MOS type transistors, changes. That is, in the device shown in Fig. 1(a), since the channel region is shared by plural MOS type transistors, according to the operation of one MOS type transistor, the effective channel length and channel width of other MOS type transistors are changed. Therefore, in the element shown in Fig. 1(a), rather than the circuit shown in Fig. 6, the terminals are connected with each other. Besides, from the aspect of formation of device, the device shown in Fig. 1(a) is more advantageous than the device shown in Fig. 6 because it is not necessary to form a gate for forming the diffusion layer 50, so that the device may be designed in a more delicate dimension and in more complicated shape.

Actually, the device shown in Fig. 1(a) is different from the device shown in Fig. 6 because the channel region of the MOS type transistor is shared. Therefore, the drain current is determined by a more complicated mechanism. Having plural pairs of source and drain, by varying the value of the potential applied to each source and drain, the drain current flowing in each transistor may be intentionally increased or decreased. Therefore, assuming one of the plural sources and drains to be a control terminal of the device having an other pair of source and drain, by applying a proper potential to the control terminal, the intrinsic characteristic of the device may be varied.

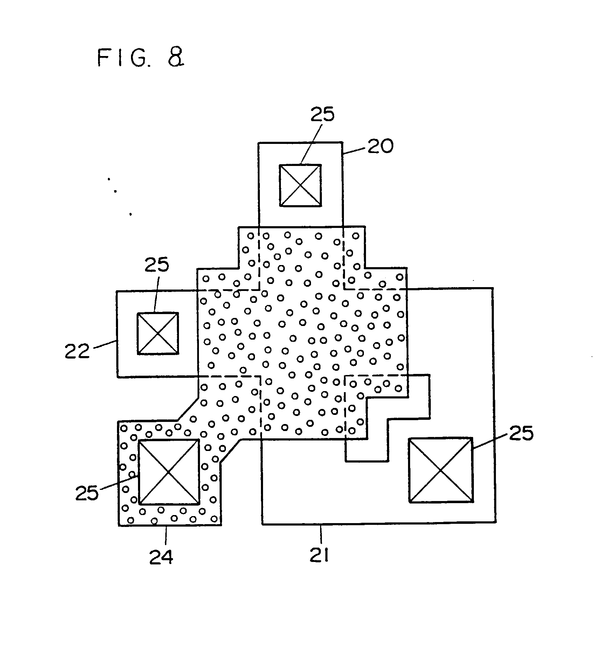

Fig. 8 shows a first embodiment of the invention, which has a modified structure of the device shown in Fig. 1(a). In Fig. 8, a diffusion layer of a set of first source 20 and first drain 21, and a set of second source 22 and second drain 23 is formed. At this time, the first drain 21 and second drain 23 in Fig. 1(a) are connected with a common P-type diffusion layer. Here, the first drain 21 and second drain 23 are collectively called the first drain 21. A common gate 24 is formed in the region to become the gate of the diffusion layer of the first source 20 and first drain 21 and the diffusion layer of the second source 22 and first drain 21.

To achieve electric connections with the diffusion layers, contact holes 25 are formed in the diffusion layer of the first source 20 and first drain 21, and the diffusion layer of the second source 22 and second drain 23. A contact hole 25 of the common gate 24 is formed in a region not electrically contacting with other diffusion regions.

The line linking the first source 20 and the first drain 21, and the line linking the second source 22 and first drain 21 intersect with each other nearly at right angle.

A characteristic feature of the element shown in Fig. 8 is that the device characteristic of specific source and drain is varied by applying a specific voltage to other source and drain terminals. Thus, when the drain is used commonly, at least only one other terminal is sufficient. Therefore, the desired function may be achieved in a structure having at least three source and drain terminals.

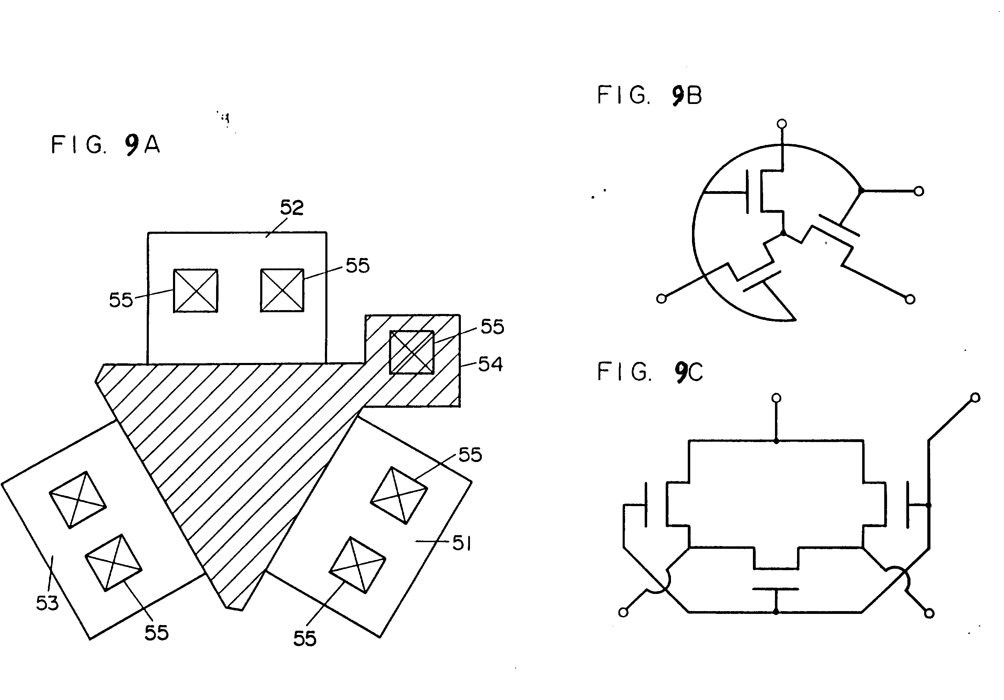

As a second example of the device having a modified structure of the element shown in Fig. 1(a), an embodiment of device having three terminals each is shown in Fig 9(a). Its equivalent circuit is as shown in Figs. 9(b), 9(c).

In Fig. 9(a), numerals 51, 52, 53 are source or drain terminals. In this example, since the width of the three terminals 51, 52, 53 is equal, it is formed in an equilateral triangle. Furthermore, in the region enclosed by the terminals, a common gate 54 is formed. Moreover, contact holes 55 are formed in the terminals 51, 52, 53 and common gate 54, and a potential may be applied to the terminals 51, 52, 53 and common gate 54 through these contact holes 55 at the time of operation of the device.

Instead of the equilateral triangle in the channel region enclosed by the terminals 51, 52, 53, any triangle may be formed by varying the width of the terminals.

Or four or more terminals may be used as well. In this case, however, the channel length tends to be longer as compared with the channel width, and it is inferior to the characteristic of the MOS type device.

In the elements shown in Fig. 1(a) and Fig. 9(a), the terminals corresponding to the source and drain are symmetrical. That is, the device characteristic is not changed at all if the first source 20 and second source 22, or the first drain 21 and second drain 23 are exchanged with each other. Accordingly, about the middle of the common gate 54, by rotating 90 degrees in Fig. 1(a) or 120 degrees in Fig. 9(a), even if operated by applying the above potential to the terminals, the same device characteristic is obtained.

In such elements, however, it is not absolutely essential that the terminals by symmetrical. That is, by applying a potential to a specific terminal, the function of controlling the current flowing in other terminals is achieved also by an asymmetrical structure not allowing to exchange the terminals. Therefore, the manner of operation of individual source terminals, drain terminals and control terminals may be fixed.

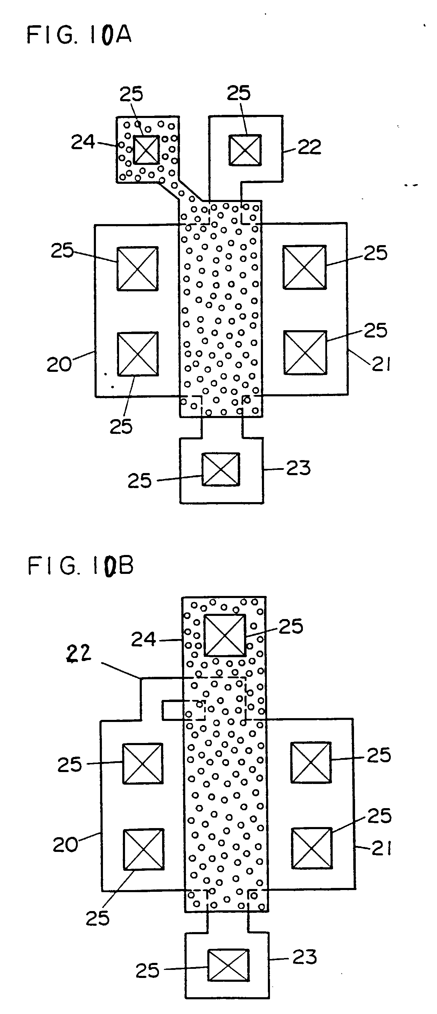

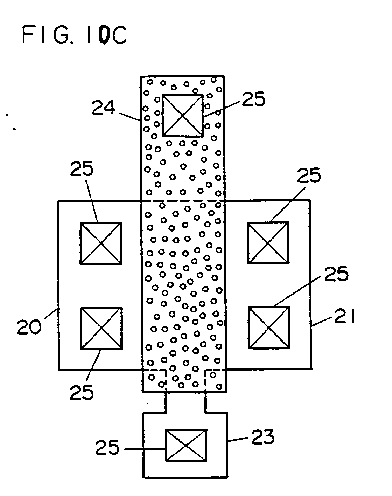

Figs. 10(a), (b), (c) refer to embodiments composed so as to control the drain current flowing in a specific MOS type element by making common the channels of the other device, with respect to the channel of the specific MOS type device. Here, the width of the channel region formed between the first source 20 and first drain 21 is set about 10 to 20 times larger than the width of the channel region formed between the second source 22 and second drain 23. In such structure, however large or small may be the potential applied to the source and drain terminals of the MOS type device than the specific MOS type device, the drain current flowing in the specific MOS type device can be changed by only about 5 to 10%. That is, in this range, the characteristic of the specific MOS type device can be varied only very slightly by the potential applied from outside.

In Fig. 10(a), there are two other control terminals, the second source 22 and second drain 23, with respect to the specific MOS type transistor possessing the first source 20 and first drain 21.

In Fig. 10(b), in a specific MOS type transistor possessing the first source 20 and first drain 21, the other two control terminals, second source 22, is connected to the first source 20.

In Fig. 10(c), there is only second drain 23 as the other control terminal in the specific MOS type transistor possessing the first source 20 and first drain 21.

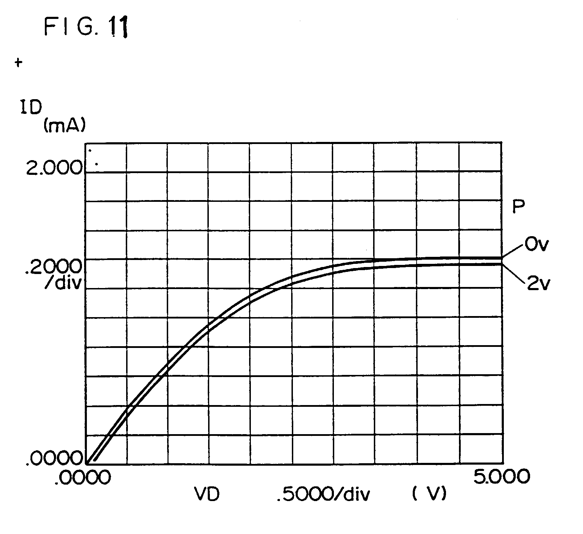

Fig. 11 shows the relation between the drain potential and drain current of the device shown in Fig. 10(c).

A potential of 0 V is applied to the first source 20 and substrate, and a potential of 5 V to the common gate 24. Potentials of 0 V and 2 V are applied to the second drain 23 to be used as parameters. To the first drain 21, a potential in a range of 0 to 5 V is applied.

The device structure shown in Fig. 10(c) is to add a second drain 23 as control terminal to the ordinary MOS type transistor with the channel width of 20 μm and channel length of 2 μm. The added MOS type transistor has the channel length of about 2 μm and channel width of about 1 μm, and the drain current flowing at this time is about 1/20 of the usual current. When potentials of 0 V, 2 V are applied to the second drain 23 which is the control terminal, it is known that the flowing drain current fluctuates about 5%. Therefore, by applying an arbitrary potential to the control terminal from outside, it is known that the characteristic of the specific MOS type transistor is changed.

The following effects are realized by using the device shown in Fig. 10(c).

The electric characteristic of the ordinary MOS type transistor is determined when forming the element as described herein. Accordingly the control is effected to satisfy the specific standard, but it is judged whether the standard is satisfied or not only by the evaluation after formation of the device.

On the other hand, to optimize the circuit operation or to design the circuit, the device is experimentally formed to collect the data of the device characteristic, and the data is fed back to the design to form a desired circuit. However, if the electric characteristic of the device can be modified after forming the device, it is possible to control so as to present the device characteristic of the highest performance. Thus, since the circuit is composed so as to change the device characteristic after the formation of the device, it is not required to replace all devices with the devices shown in Fig. 10(c), and only specific devices largely affecting the circuit characteristic may be modified. At this time, the potential to be applied to the control terminal of the replaced device may be fixed at a specific external potential through an output terminal, or the potential may be applied to the control terminal through feedback loop so as to be adjusted by self-matching. Thus, the element with excellent performance may be formed at a high yield, and optimization of the circuit operation or data collection in designing of circuit may be done easily.

In the device shown in Fig. 1(a), the majority of the channel region overlaps with four MOS type tansistors. Accordingly, the drain current flowing in each MOS type transistor is exposed to the effect to the maximum effect by the potential applied to the transistors. The degree of such effect may be varied arbitrarily. That is, by reducing the overlap of the channel region, the mutual effect may be decreased.

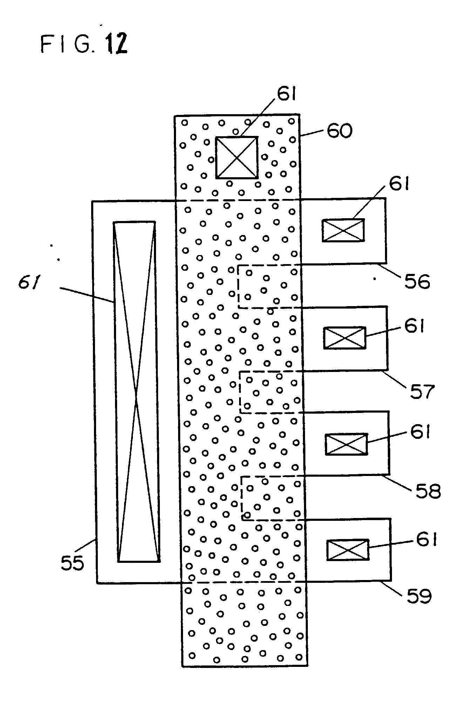

An embodiment of an element intended to reduce the overlap of the channel region is shown in Fig 12. In Fig. 12, a first source 55 is common, and in order to reduce the overlap of the channels formed by each pair of drain and source, four drains (first drain 56, second drain 57, third drain 58, fourth drain 59) are disposed parallel to each other. Furthermore, a common gate 60 is formed in the region enclosed by the first source 55 and the four drains 56 to 59.
In addition, contact holes 61 are formed in the first source 55, four drains 56 to 59, and common gate 60.

At this time, since the channel regions overlap only by about 20 to 30%, the rate of the drain current influenced by the potential applied to other drain terminals is about 20% only. By such configuration of the sources and drains, the degree of mutually affecting with other drain terminals may be arbitrarily set.

As explained herein, the devices shown in Fig. 1(a) and Fig. 9(a) can possess characteristics that cannot be obtained in the device formed merely by combining the conventional MOS type transistors. By the potentials applied mutually to other transistors, the drain current flowing in the specific MOS type transistor varies, and this characteristics is convenient for composing a circuit of complicated and mutual connections such as the neuron (nerve circuit).

In other words, as shown in Figs. 3(a) and 3(b), in spite of one device, the same operation as the circuit composed of four or six MOS type transistors is realized, and therefore the area for disposing the device may be reduced to 20 to 50%.

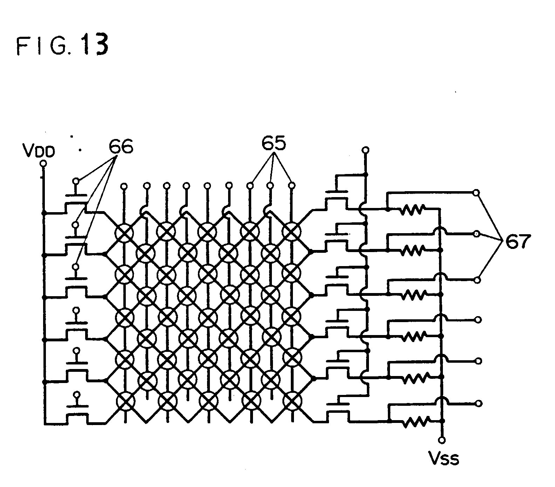

Fig. 13 shows an embodiment of a circuit composed by using the devices shown in Fig. 1(a).

The device shown in Fig. 13 is indicated by the o mark, and the x mark in the o mark refers to the four straight lines seen from the center of the x, corresponding respectively to the first source 20, first drain 21, second source 22 and second drain 23. The straight line above and below the o mark indicates the common gate 24. Thus formed devices, 41 devices in this example, are arranged in a matrix, and the gate is common in the vertical direction, and the gate terminals are as many as the number of rows of arrangement, or nine gate terminals 65 in this example. Each element forms a part of an input terminal 66 and a part of an output terminal 67 by mutually connecting the first source 20 and first drain 21. Moreover, each element forms a part of an input terminal 66 and a part of an output terminal 67 by mutually connecting the second source 22 and second drain 23.

An electric signal applied to an input terminal 66 is converted on the matrix shown in Fig. 13 , and is delivered to an output terminal 67. All outputs are affected by the electric signals from the input terminals 66, and therefore one output may include all input information, and therefore the data is holographic (multiplex).

Practically, for example, a character or image may be recognized by the information read in through the image scanner. Such processing is required in order to judge if identical or not even when the reading position is deviated or the contrast difference is absorbed because the relation of contrast of adjacent pieces of information is important.

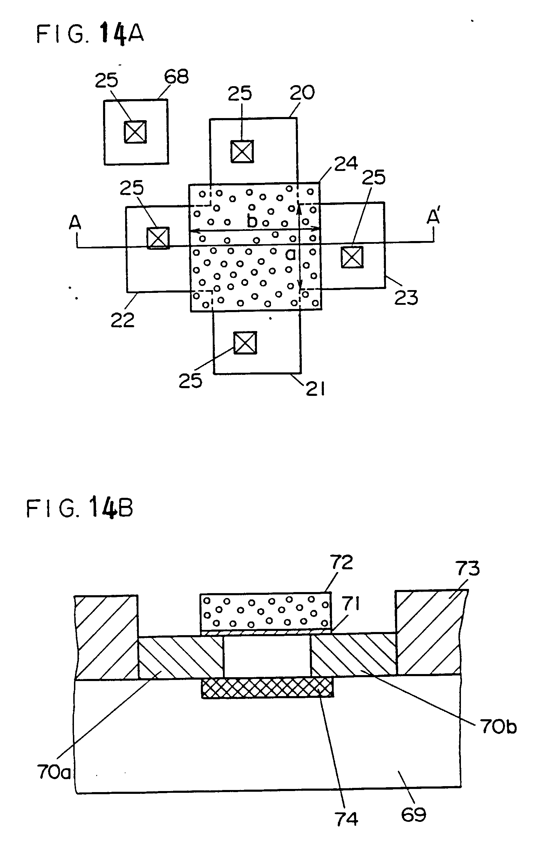

As other embodiment of the invention, a structure of junction type field effect transistor (JFET) is shown in Fig. 14. Fig. 14(a) is a plan view of JFET. As far as the plan view is concerned, there is nothing different from the plan view of the device shown in Fig. 1(a). In Fig. 1 (a), the source and drain of the JFET are composed of impurities of the same conductive type. Diffusion layers of a set of first source 20 and first drain 21 and a set of second source 22 and second drain 23 are formed. A common gate 24 is formed in the region of the gate of the diffusion layer of first source 20 and first drain 21 and the gate of the diffusion layer of second source 22 and second drain 23.

To achieve electrical connections of diffusion layers, contact holes 25 are formed in the diffusion layer of first source 20 and first drain 21, and the diffusion layer of second source 22 and second drain 23. A contact hole 25 of the common gate 24 is formed in a region not contacting electrically with the other diffusion layers.

The line linking the first source 20 and first drain 21, and the line linking the second source 22 and second drain 23 are intersecting almost at right angle. There is also a region 68 for applying a substrate voltage.

Fig. 14(b) is a sectional view of the element in line A-A' shown in Fig. 14(a) during operation of JFET. In Fig. 14(b), a diffusion layer 70a to be the second source 22 and a diffusion layer 70b to be the second drain 23 are formed in the silicon substrate 69. A gate oxide film 71 is formed on the silicon substrate 69 on the second source 22 and second drain 23. A gate electrode 72 made of polysilicon is formed on the gate oxide film 71. When a potential over the threshold is applied to the gate electrode 72, the diffusion layer 70a and diffusion layer 70b are connected, and a channel 74 is formed at a deep position inside the substrate immediately beneath the gate. There is also an insulation film 73 for separating the elements in the other region than the element region.

The manner of applying the potential is same as in the ordinary MOS type transistor. Since nothing is different in the transistor characteristic, the foregoing explanation on the MOS type transistor is entirely applicable to the JFET. That is, the drain current flowing in a specific transistor may be controlled by varying the potential applied to other transistors. Furthermore, having plural pairs of source and drain, by varying the value of the potential applied to each source and drain, the drain current flowing in the transistor may be intentionally increased or decreased. As a result, assuming one of the plurality of sources and drains to be a control terminal of the transistor having other pair of source and drain, by applying an appropriate potential to the control terminal, the intrinsic state of instability of drift in operation of the device may be intentionally created. Besides, the devices of high performance may be formed at high yield, and the optimization of the circuit operation and data collection in designing of circuit may be achieved easily.

According to the invention, as defined in the appended claims and as described herein, by employing the conventional transistor manufacturing method, the hitherto impossible device characteristics may be realized. That is, having plural pairs of source and drain, by varying the value of the potential applied to each source and drain, the drain current flowing in the device may be intentionally increased or decreased. As a result, assuming one of the plurality of sources and drains to be a control terminal of the device having other pair of source and drain, by applying an appropriate potential to abovementioned control terminal, the intrinsic characteristic of the device may be varied, and the state of instability of drift in operation may be intentionally created. Thus, a desired circuit may be composed easily in the circuit design. Furthermore, the hitherto impossible circuit may be composed. In addition, since the electric characteristic of the device may be varied after forming a device or a circuit, it may be possible to cause characteristics of the highest performance. Since the device characteristics can be freely varied, the devices of superb performance may be formed at high yield, and optimization of circuit operation and data collection in circuit design may be achieved easily.

**Claims**

1.  A field effect transistor device comprising:

    (a) a semiconductor substrate (26);

    (b) first and second diffusion layers (27a,27b) formed in said semiconductor substrate;

    (c) a third diffusion layer functioning as a control terminal, said third diffusion layer formed at a position independent from said first and second diffusion layers (27a,27b) in said semiconductor substrate; and

    (d) a common gate (24), said first, second, and third diffusion layers being formed externally around said common gate;

    wherein a single channel region (33) is formed beneath the gate and between the diffusion layers.

2.  A semiconductor device according to claim 1, wherein said channel (33) is formed in the surface region of said semiconductor substrate (26).

3.  A semiconductor device according to claim 1, wherein said channel (33) is formed inside said semiconductor substrate (26).

4.  A semiconductor device according to claim 1, wherein said third diffusion layer is formed on a line nearly orthogonal to the line linking said first and second diffusion layers (27a,27b).

5.  A semiconductor device according to claim 1, wherein the shape of said channel (33) is triangular.

6.  A semiconductor device according to any one of the preceding claims wherein a fourth diffusion layer is formed in the semiconductor substrate, said diffusion layers being arranged as two pairs of diffusion layers, each pair having said common gate therebetween.

7.  A semiconductor device according to claim 6, wherein one diffusion layer of one of said pairs is formed in common connection with one diffusion layer of the other of said pairs.

**Patentansprüche**

1.  Eine Feldeffekttransistorvorrichtung mit:

    (a) einem Halbleitersubstrat (26);

    (b) ersten und zweiten Diffusionsschichten (27a, 27b), die in dem Halbleitersubstrat ausgebildet sind;

    (c) einer dritten Diffusionsschicht, die als Steueranschluß wirkt, wobei die dritte Diffusionsschicht an einer von der ersten und zweiten Diffusionsschicht (27a, 27b) unabhängigen Position in dem Halbleitersubstrat ausgebildet ist; und

    (d) einem gemeinsamen Gate (24), wobei die erste, zweite und dritte Diffusionsschicht extern um das gemeinsame Gate herum ausgebildet sind;

    wobei ein einzelner Kanalbereich (33) unterhalb des Gates und zwischen den Diffusionsschichten ausgebildet ist.

2.  Eine Halbleitervorrichtung gemäß Anspruch 1, wobei der Kanal (33) in dem Oberflächengebiet des Halbleitersubstrats (26) ausgebildet ist.

3.  Eine Halbleitervorrichtung gemäß Anspruch 1, wobei der Kanal (33) innerhalb des Halbleitersubstrats (26) ausgebildet ist.

4. Eine Halbleitervorrichtung gemäß Anspruch 1, wobei die dritte Diffusionsschicht auf einer Linie ausgebildet ist, die nahezu senkrecht ist zu der die erste und zweite Diffusionsschicht (27a, 27b) verbindenden Linie ist.

5. Eine Halbleitervorrichtung gemäß Anspruch 1, wobei die Form des Kanals (33) dreieckig ist.

6. Eine Halbleitervorrichtung gemäß einem der vorhergehenden Ansprüche, wobei eine vierte Diffusionsschicht in dem Halbleitersubstrat ausgebildet ist, wobei die Diffusionsschichten als zwei Paare von Diffusionsschichten angeordnet sind, wobei jedes Paar ein gemeinsames Gate dazwischen aufweist.

7. Eine Halbleitervorrichtung gemäß Anspruch 6, wobei eine Diffusionsschicht eines der Paare in gemeinsamer Verbindung mit einer Diffusionsschicht des anderen Paars ausgebildet ist.

**Revendications**

1. Dispositif de transistor à effet de champ comprenant :

(a) un substrat semiconducteur (26) ;
(b) des première et seconde couches de diffusion (27a, 27b) formées dans ledit substrat semiconducteur ;
(c) une troisième couche de diffusion jouant le rôle de borne de commande, ladite troisième couche de diffusion étant formée en une position indépendante desdites première et seconde couches de diffusion (27a, 27b) dans ledit substrat semiconducteur ; et
(d) une grille commune (24), lesdites première, seconde et troisième couches de diffusion étant formées de façon externe autour de ladite grille commune,

dans lequel une unique région de canal (33) est formée au-dessous de la grille et entre les couches de diffusion.

2. Dispositif à semiconducteur selon la revendication 1, dans lequel ledit canal (33) est formé dans la région de surface dudit substrat semiconducteur (26).

3. Dispositif à semiconducteur selon la revendication 1, dans lequel ledit canal (33) est formé à l'intérieur dudit substrat semiconducteur (26).

4. Dispositif à semiconducteur selon la revendication 1, dans lequel ladite troisième couche de diffusion est formée sur une ligne pratiquement orthogonale à la ligne reliant lesdites première et seconde couches de diffusion (27a, 27b).

5. Dispositif à semiconducteur selon la revendication 1, dans lequel la forme dudit canal (33) est triangulaire.

6. Dispositif à semiconducteur selon l'une quelconque des revendications précédentes, dans lequel une quatrième couche de diffusion est formée dans le substrat semiconducteur, lesdites couches de diffusion étant agencées en tant que deux paires de couches de diffusion, chaque paire comportant ladite grille commune entre.

7. Dispositif à semiconducteur selon la revendication 6, dans lequel une couche de diffusion d'une desdites paires est formée selon une connexion commune avec une couche de diffusion de l'autre desdites paires.

## FIG. IA

FIG. 1B

22

27a

28

24

26

27b

31

23

FIG. 2A

FIG. 2B

14

FIG. 3A

FIG. 3B

F I G. 4A

F I G. 4B

FIG. 5

FIG. 6

FIG. 7A

FIG. 7B

FIG. 8

FIG. 9A

FIG. 9B

FIG. 9C

52

55

55

55

54

55

51

53

55

55

EP 0 403 267 B1

FIG. 10A

FIG. 10B

# FIG. 10C

FIG. 11

FIG. **12**

FIG. 13

FIG. 14A

FIG. 14B

PRIOR ART
FIG. 15A

5a,5b

7

4       I       2

PRIOR ART
FIG. 15B

6       7       4       2

3

I

5a,5b